# EUROPEAN PATENT SPECIFICATION

(11) **EP 2 778 262 B1**
(45) Date of publication and mention of the grant of the patent: **08.05.2019**
(21) Application number: 14159998.5
(22) Date of filing: 14.03.2014
(51) Int. Cl.: C25D 7/12, C25D 3/38, H01L 31/0216, H01L 31/068, C25D 5/00

(54) **COPPER PLATING METHOD FOR THE MANUFACTURE OF SOLAR CELLS**
KUPFERABSCHEIDUNG FÜR DIE HERSTELLUNG VON SOLARZELLEN
PROCÉDÉ DE PLACAGE DE CUIVRE POUR LA FABRICATION DE CELLULES SOLAIRES

(30) Priority: 15.03.2013 US 201361792190 P
(43) Date of publication of application: 17.09.2014
(73) Proprietor: MacDermid Enthone America LLC, South Plainfield NJ 07080 (US)
(72) Inventor: Bernards, Roger, South Haven, MN 55382 (US); Bellemare, Richard, Marlboro, NJ 07746 (US)
(74) Representative: Schollweck, Susanne

(56) References cited:
- EP-A1- 2 648 222
- EP-A1- 2 672 520
- EP-A2- 1 092 790
- US-A- 4 376 685
- US-A- 5 174 886
- US-A1- 2012 174 827
- US-A1- 2012 175 744
- US-A1- 2012 282 731

## Description

### Field of the Invention

The present technology generally relates to methods for plating copper. Specifically, the present technology includes a copper plating solution comprising a source of copper ions and a conductivity salt provided as lithium sulfate wherein the copper plating solution has a pH between 1.7 and 3.5 and is free of chloride ions. This technology could be useful in the manufacture of solar silicon wafers.

### Background of the Invention

The present application is related to copper plating. Copper plating is used in a number of technical fields, for example in the field of printed circuitry. Copper can be plated onto a number of substrates for example printed circuit boards (PCB), solar cells and integrated circuit (IC) substrates.

Printed circuit boards refer to solid circuits that are formed from a conductive material (commonly, copper or copper plated with solder or gold) that is positioned on opposite sides of an insulating material (commonly glass-fiber-reinforced epoxy resin). Where the printed circuit board has two conductive surfaces positioned on opposite sides of a single insulating layer, the resulting circuit board is known as a "double sided circuit board." To accommodate even more circuits on a single board, several copper layers are sandwiched between boards of insulating material to produce a multi-layer circuit board.

An integrated circuit or monolithic integrated circuit (also referred to as an IC, a chip, or a microchip) is a set of electronic circuits on one small plate ("chip") of semiconductor material, normally silicon. This can be made to be much smaller than a discrete circuit made from independent components. Integrated circuits are used in a large amount of electronic equipment today. Computers, mobile phones, and other digital home appliances all utilize integrated circuits.

A solar cell (also called a photovoltaic (PV) cell) is an electrical device that converts the energy of light into electricity by the photovoltaic effect. It is a form of photoelectric cell (in that its electrical characteristics-- e.g. current, voltage, or resistance-- vary when light is incident upon it) which, when exposed to light, can generate and support an electric current without being attached to any external voltage source. A typical silicon PV cell is composed of a thin wafer consisting of an ultra-thin layer of phosphorus-doped (N-type) silicon on top of a thicker layer of boron-doped (P-type) silicon. An electrical field is created near the top surface of the cell where these two materials are in contact, called the P-N junction. When sunlight strikes the surface of a PV cell, this electrical field provides momentum and direction to light-stimulated electrons, resulting in a flow of current when the solar cell is connected to an electrical load.

The process of fabricating conventional single- and polycrystalline silicon PV cells begins with very pure semiconductor-grade polysilicon - a material processed from quartz and used extensively throughout the electronics industry. The polysilicon is then heated to melting temperature, and trace amounts of boron are added to the melt to create a P-type semiconductor material. Next, an ingot, or block of silicon is formed, commonly using one of two methods: 1) by growing a pure crystalline silicon ingot from a seed crystal drawn from the molten polysilicon or 2) by casting the molten polysilicon in a block, creating a polycrystalline silicon material. Individual wafers are then sliced from the ingots using wire saws and then subjected to a surface etching process. After the wafers are cleaned, they are placed in a phosphorus diffusion furnace, creating a thin N-type semiconductor layer around the entire outer surface of the cell. Next, an anti-reflective coating is applied to the top surface of the cell.

An aluminized conductive material is deposited on the back (positive) surface of each cell, restoring the P-type properties of the back surface by displacing the diffused phosphorus layer. The aluminized conductive material is sometimes applied by screen-printing a metal paste, such as an aluminum paste.

Electrical contacts are also imprinted on the top (negative) surface of the cell. The grid-like metal contact made up of fine "fingers" and larger "bus bars" are typically screenprinted onto the top surface. This is typically done using a silver paste. However, silver pastes are very expensive. One step towards reducing the cost of PV cells is to print a finer silver grid and improve the conductivity of it by topcoating with various, less costly electroplated coatings such as nickel, copper, tin and various combinations of each. The plating of silver pastes is readily achieved by immersing the screen printed and fired wafers into a plating solution with the application of direct current or LIP plating. The metals are then deposited directly onto the silver paste without requiring any pretreatments due to the high conductivity and very thin oxide on the silver particles.

Common copper plating solutions include bright acid copper plating solutions, copper plating solutions containing chelated compounds, alkaline copper plating solutions and cyanide containing copper plating solutions. Copper plating solutions containing chelated compounds are not always desirable because the waste treatment of chelated copper solutions is more costly than non-chelated copper solutions. Alkaline copper plating solutions are not always desirable because alkaline solutions require a chelator or strong complexor like cyanide. Cyanide is a poison and is a health risk.

One particular copper plating method is bright acid copper plating. Bright acid copper plating involves high quantities of sulfuric or other acid. Bright acid copper plating also requires chloride ions in order to make a smooth deposit. US2012282731 A1 discloses a method of photoplating a metal contact onto a surface of a cathode of a photovoltaic device using light induced plating technique. The copper plating solution used for said method contains copper sulfate and 45 to 225 ml/L of concentrated sulfuric acid.

Applicants determined that chloride ions and acid containing plating solutions are not suitable for certain plating applications. For example, such solutions are not suitable for plating over metal seed layers on silicon solar cell wafers. The acid will cause delamination of the seed layer meaning that the conductive seed layer to the silicon wafer (usually silver paste or electroless nickel seed layer) will lose adhesion to the silicon wafer surface and will easily peel off. The chloride ions will adversely affect materials on the backside of the solar cell wafer, such as the aluminum paste by causing the aluminum paste to dissolve into the copper plating solution. As such it is desirable to develop a new copper plating solutions that does not produce these adverse effects.

### Summary of the Invention

The present technology generally relates to methods for plating copper. Specifically, the present technology includes a copper plating solution comprising a source of copper ions and a conductivity salt provided as lithium sulfate, wherein the copper plating solution has a pH between 1.7 and 3.5 and is free of chloride ions. This technology could be useful in the manufacture of solar silicon wafers.

An embodiment of the current method of plating copper onto a substrate comprises providing a substrate, wherein the substrate is a metal seed layer on a silicon solar cell wafer comprising an aluminum backside, contacting the substrate with a copper plating solution comprising a source of copper ions and a conductivity salt provided as lithium sulfate, wherein said copper plating solution has a pH between 1.7 and 3.5 and is free of chloride ions.

The source of copper ions can be copper sulfate. The pH can be between 2.3 and 3.0. The additive is selected from the group of 2 mercaptoimidazole, 2 mercaptothiazole, 3-(carboxymethyl)benzothiazolium bromide, 2 mercapto-1-methylimidazole and 2 aminothiazole.

The copper plating solution comprises a source of copper ions and a conductivity salt provided as lithium sulfate, wherein said copper plating solution has a pH between 1.7 and 3.5 and is free of chloride ions.

### Detailed Description of the Preferred Embodiment(s)

The present technology generally relates to methods for plating copper. Specifically, the present technology includes a copper plating solution comprising a source of copper ions and a conductivity salt provided as lithium sulfate, wherein the copper plating solution has a pH between 1.7 and 3.5 and is free of chloride ions. This technology could be useful in the manufacture of solar silicon wafers. The embodiments disclosed herein are intended to be illustrative and it will be understood that the invention is not limited to these embodiments since modification can be made by those of skill in the art without departing from the scope of the present disclosure.

The current copper plating solution comprises a source of copper ions and a conductivity salt provided as lithium sulfate; the copper plating solution has a pH between 1.7 and 3.5 and is free of chloride ions.

The current copper plating solution is useful for the manufacture of solar cells.

The source of copper ions can be a source that is known in the art that will provide copper ions. Examples of possible sources of copper ions include copper sulfate, copper acetate, copper carbonate, and copper oxide. A preferred source of copper ions is copper sulfate. The source of copper ions can be added in the following amounts 10g/L to 68g/L copper ion.

The conductivity salt is lithium sulfate. The conductivity salt can be added in the following amounts: 1.0g/L up to the saturation point of the salt in the solution such that the maximum concentration of the salt is reached and further additions would precipitate out of solution. Applicants have discovered that the present plating solutions are enhanced by addition of conductivity salts, particularly lithium sulfate. Conductivity salts generally and lithium sulfate in particular enhance plating distribution and are highly soluble in the plating solution. Without conductivity salts, the plating distribution is poor due to the lack of strong acid in the present plating solution.

In other embodiments optional components that will not compromise the copper plating solution can also be added. An example of such an optional component is an additive selected from 2 mercaptoimidazole, 2 mercaptothiazole, 3-(carboxymethyl)benzothiazolium bromide, 2 mercapto-l-methylimidazole, 2 aminothiazole, and dyes such as Janus green B. These additives have been shown to enhance the deposit brightness/smoothness/appearance in spite of the fact that the bath does not contain chloride ion which is normally required for bright acid copper plating.

In other embodiments optional components that will not compromise the copper plating solution can also be added. Examples of such optional components are surfactants and polymers such as polyethylene glycol, nonyl phenol ethoxylates, nonionic, anionic and cationic surfactants, and buffers for maintaining the desired pH.

The present method includes providing a substrate and contacting the substrate with a copper plating solution that comprises copper ions and a conductivity salt provided as lithium sulfate. The copper plating solution has a pH between 1.7 and 3.5 and is free of chloride ions.

The substrate is a solar cell, more specifically, a metal seed layer on a silicon solar cell wafer. Examples of possible metal seed layers include silver paste, electroless nickel, electroplated nickel and aluminum. As discussed above, typical acidic copper plating solutions will negatively affect metal seed layers by causing the seed layer to lose adhesion to the silicon wafer substrate.

The present method is useful for direct contact electroplating of solar cells. This present method is also useful in light induced electroplating of solar cells where an electrical contact is made to the backside of the solar cell and a light is shined onto the solar cell such that plating will occur onto the front side of the solar cell.

The source of copper ions can be a source that is known in the art that will provide copper ions. Examples of possible sources of copper ions include copper sulfate, copper acetate copper carbonate and copper oxide. A preferred source of copper ions is copper sulfate. The source of copper ions can be added in the following amounts 10 to 68g/L copper metal.

The conductivity salt is lithium sulfate. The conductivity salt can be added in the following amounts 1.0g/L up to the saturation point of the salt in the solution such that the maximum concentration of the salt is reached and further additions would precipitate out of solution.

In other embodiments optional components that will not compromise the copper plating solution can also be added. An example of such an optional component is and additive selected from 2 mercaptoimidazole, 2 mercaptothiazole, 3-(carboxymethyl)benzothiazolium bromide, 2 mercapto-l-methylimidazole, 2 aminothiazole, and dyes such as Janus green B.

In other embodiments optional components that will not compromise the copper plating solution can also be added. Examples of such optional components are surfactants and polymers such as polyethylene glycol, nonyl phenol ethoxylates, nonionic, anionic and cationic surfactants and buffers for maintaining the desired pH.

The current contacting step may take place at a pH suitable to obtain bright, smooth, evenly distributed copper plating. The desired result may be achieved at a pH of 1.7 to 3.5, more preferably 2.3 to 3.0.

The current contacting step may take place at a temperature suitable to obtain bright, smooth, evenly distributed copper plating. For example, the desired result may be achieved at ambient temperature up to 80 degrees celsius.

The current contacting step may take place for a duration of time suitable to obtain bright, smooth, evenly distributed copper plating. For example, the desired result may be achieved in 1 to 20 minutes.

Additional optional steps may also be added. For example steps could include rinsing, neutralizing, drying, subsequent electroplating and baking.

A person familiar with the technology will understand that the conditions described above can be varied and adjusted to achieve the desired metallization.

### Example 1

In one non-limiting embodiment, a solar cell with an efficiency of 18% is electroplated in a solution containing 80g/L copper sulfate pentahydrate, 100g/L lithium sulfate, pH adjusted to 2.3 with sulfuric acid or sodium hydroxide. A silver paste containing solar cell with an aluminum containing backside is electroplated at 50 ASF (5 A/dm²) for 2 minutes. A matte copper deposit is obtained on the silver paste seed layer. The efficiency of the solar cell after plating increased to 19%, the aluminum backing of the solar cell remained unaffected by the plating solution. The silver paste seed layer adhesion to the silicon wafer was not compromised.

### Example 2

In one non-limiting embodiment, a solar cell with an efficiency of 18% is electroplated in a solution containing 80g/L copper sulfate pentahydrate, 100g/L lithium sulfate, 0.2g/L of a thio-imidazole compound, the pH is adjusted to 2.3 with sulfuric acid or sodium hydroxide. A silver paste containing solar cell with aluminum back is light induced plated at 50 ASF (5 A/dm²) for 2 minutes. A bright copper deposit is obtained on the silver paste seed layer. The efficiency of the solar cell after plating increased to 19.2%, the aluminum backing of the solar cell remained unaffected by the plating solution. The silver paste seed layer adhesion to the silicon wafer was not compromised.

## Claims

1. A method of plating copper onto a substrate comprising:
providing a substrate, wherein said substrate is a metal seed layer on a silicon solar cell wafer comprising an aluminum backside; and
contacting said substrate with a copper plating solution comprising a source of copper ions and a lithium sulfate conductivity salt wherein said copper plating solution has a pH between 1.7 and 3.5 and is free of chloride ions and wherein the backside of the silicon solar cell wafer remains unaffected by the plating solution.

2. The method of claim 1 wherein said source of copper ions is copper sulfate.

3. The method of claim 1 wherein said pH is between 2.3 and 3.0.

4. The method of claim 1 wherein the copper plating solution further comprises an additive selected from the group of 2-mercaptoimidazole, 2-mercaptothiazole, 3-(carboxymethyl)benzothiazolium bromide, 2-mercapto-1-methylimidazole and 2-aminothiazole.

5. The method according to claim 1, wherein the lithium sulfate conductivity salt is present anywhere from 1 g/L up to the saturation point of the salt.

6. The method according to claim 1, wherein the plating is carried out at a temperature between ambient and 80° C.

7. The method according to claim 1, wherein the plating occurs from 1 to 20 minutes.

## Patentansprüche

1. Verfahren zum Plattieren von Kupfer auf ein Substrat, das umfasst:
Bereitstellen eines Substrats, wobei das Substrat eine Metallkeimschicht auf einem Siliziumsolarzellenwafer ist, der eine Aluminium-Rückseite umfasst; und
Kontaktieren des Substrats mit einer Kupferplattierungslösung, die eine Kupferionenquelle und ein Lithiumsulfat-Leitfähigkeitssalz umfasst, wobei die Kupferplattierungslösung einen pH-Wert zwischen 1,7 und 3,5 aufweist und frei von Chloridionen ist und wobei die Rückseite des Siliziumsolarzellenwafers unberührt von der Plattierungslösung bleibt.

2. Verfahren nach Anspruch 1, wobei die Kupferionenquelle Kupfersulfat ist.

3. Verfahren nach Anspruch 1, wobei der pH-Wert zwischen 2,3 und 3,0 liegt.

4. Verfahren nach Anspruch 1, wobei die Kupferplattierungslösung ferner ein Additiv umfasst, das aus der Gruppe von 2-Mercaptoimidazol, 2-Mercaptothiazol, 3-(Carboxymethyl)benzothiazoliumbromid, 2-Mercapto-1-methylimidazol und 2-Aminothiazol ausgewählt ist.

5. Verfahren nach Anspruch 1, wobei das Lithiumsulfat-Leitfähigkeitssalz irgendwo zwischen 1 g/L bis zum Sättigungspunkt des Salzes vorliegt.

6. Verfahren nach Anspruch 1, wobei das Plattieren bei einer Temperatur zwischen Umgebungstemperatur und 80°C ausgeführt wird.

7. Verfahren nach Anspruch 1, wobei das Plattieren von 1 bis 20 Minuten erfolgt.

## Revendications

1. Procédé pour plaquer du cuivre sur un substrat, comprenant :
la fourniture d'un substrat, lequel substrat est une couche de germe métallique sur une plaquette de cellule solaire en silicium comprenant une face d'envers en aluminium ; et
la mise en contact dudit substrat avec une solution de placage de cuivre comprenant une source d'ions cuivre et un sel de conductivité sulfate de lithium,
ladite solution de placage de cuivre ayant un pH compris entre 1,7 et 3,5 et étant exempte d'ions chlorure, et la face d'envers de la plaquette de cellule solaire en silicium restant non affectée par la solution de placage.

2. Procédé selon la revendication 1, dans lequel ladite source d'ions cuivre est le sulfate de cuivre.

3. Procédé selon la revendication 1, dans lequel ledit pH est compris entre 2,3 et 3,0.

4. Procédé selon la revendication 1, dans lequel la solution de placage de cuivre comprend en outre un additif choisi dans le groupe comprenant le 2-mercaptoimidazole, le 2-mercaptothiazole, le bromure de 3-(carboxyméthyl)benzothiazolium, le 2-mercapto-1-méthylimidazole et le 2-aminothiazole.

5. Procédé selon la revendication 1, dans lequel le sel de conductivité sulfate de lithium est présent en n'importe quelle proportion allant de 1 g/l jusqu'au point de saturation du sel.

6. Procédé selon la revendication 1, dans lequel le placage est effectué à une température comprise entre la température ambiante et 80°C.

7. Procédé selon la revendication 1, dans lequel le placage est réalisé pendant 1 à 20 minutes.
